# EUROPÄISCHE PATENTSCHRIFT

(11) **EP 0 863 588 B1**
(45) Veröffentlichungstag und Bekanntmachung des Hinweises auf die Patenterteilung: **12.11.2003**
(21) Anmeldenummer: 98101690.0
(22) Anmeldetag: 02.02.1998
(51) Int. Cl.: H01S 3/00, H01S 5/00, G02B 27/09

(54) **Laseroptik sowie Diodenlaser**
Laseroptics and laserdiode
Optique pour laser et laser à diode

(30) Priorität: 01.02.1997 DE 19703825; 14.02.1997 DE 19705574
(43) Veröffentlichungstag der Anmeldung: 09.09.1998
(73) Patentinhaber: Laserline Gesellschaft für Entwicklung und Vertrieb von Diodenlasern GmbH, 56070 Koblenz (DE)
(72) Erfinder: Krause, Volker, 67292 Kirchheimbolanden (DE); Ullmann, Christoph Dr., 53639 Königswinter (DE)
(74) Vertreter: Graf, Helmut, Dipl.-Ing.

(56) Entgegenhaltungen:
- DE-A- 4 438 368
- DE-A- 19 514 626
- DE-A- 19 743 322
- GB-A- 387 803
- GB-A- 2 319 630
- US-A- 5 513 201

## Beschreibung

Die Erfindung bezieht sich auf eine Laseroptik gemäß Oberbegriff Patentanspruch 1 sowie auf einen Diodenlaser entsprechend Oberbegriff Patentanspruch 22.

Im Gegensatz zu konventionellen Laserstrahlquellen, die einen Strahldurchmesser von einigen mm bei einer geringen Strahldivergenz im Bereich von wenigen mrad aufweisen, zeichnet sich die Strahlung eines Halbleiter-Diodenlaser (nachstehend auch "Diodenlaser") durch einen stark divergenten Strahl mit einer Divergenz > 1000 mrad aus. Hervorgerufen wird dies von der auf < 1 µm Höhe begrenzten Austrittsschicht, an der ähnlich der Beugung an einer spaltförmigen Öffnung, ein großer Divergenzwinkel erzeugt wird. Da die Ausdehnung der Austrittsöffnung in der Ebene senkrecht und parallel zur aktiven Halbleiterschicht unterschiedlich ist, kommen verschiedene Strahldivergenzen in der Ebene senkrecht und parallel zur aktiven Schicht zustande.

Um eine Leistung von 20 - 40 W für einen Diodenlaser zu erreichen, werden zahlreiche Laser-Chips auf einem sog. Barren zu einem Laserbauelement zusammengefaßt. Üblicherweise werden hierbei 10 - 50 einzelne Emittergruppen in einer Reihe in der Ebene parallel zur aktiven Schicht angeordnet. Der resultierende Strahl eines solchen Barrens hat in der Ebene parallel zur aktiven Schicht einen Öffnungswinkel von ca. 10° und einen Strahldurchmesser von ca. 10 mm. Die resultierende Strahlqualität in dieser Ebene ist um ein Vielfaches geringer als die sich ergebende Strahlqualität in der zuvor beschriebenen Ebene senkrecht zur aktiven Schicht. Auch bei einer möglichen zukünftigen Verringerung der Divergenzwinkel von Laser-Cips bleibt das stark unterschiedliche Verhältnis der Strahlqualität senkrecht und parallel zur aktiven Schicht bestehen.

Der Strahl verfügt aufgrund der zuvor beschriebenen Strahlcharakteristik über einen großen Unterschied der Strahlqualität in beiden Richtungen senkrecht und parallel zur aktiven Schicht. Der Begriff der Strahlqualität wird dabei beschrieben durch den M² Parameter. M² ist definiert durch den Faktor, mit dem die Strahldivergenz des Diodenlaserstrahles über der Strahldivergenz eines beugungsbegrenzten Strahles gleichen Durchmessers liegt. In dem oben gezeigten Fall verfügt man in der Ebene parallel zur aktiven Schicht über einen Strahldurchmesser, der um den Faktor 10.000 über dem Strahldurchmesser in der senkrechten Ebene liegt. Bei der Strahldivergenz verhält es sich anders, d.h. in der Ebene parallel zur aktiven Schicht wird eine fast 10-fach kleinere Strahldivergenz erreicht. Der M² Parameter in der Ebene parallel zur aktiven Schicht liegt also um mehrere Größenordnungen über dem M² Wert in der Ebene senkrecht zur aktiven Schicht.

Ein mögliches Ziel einer Strahlformung ist es, einen Strahl mit nahezu gleichen M² Werten in beiden Ebenen, d.h. senkrecht und parallel zur aktiven Schicht zu erreichen. Bekannt sind derzeit folgende Verfahren zur Umformung der Strahlgeometrie durch die eine Annäherung der Strahlqualitäten in den beiden Hauptebenen des Strahles erreicht wird.

Mittels eines Faserbündels lassen sich linienförmige Strahlquerschnitte durch Umordnen der Fasern zu einem kreisrunden Bündel zusammenfassen. Solche Verfahren sind z.B. in den US-Patentschriften 5 127 068, 4 763 975, 4 818 062, 5 268 978 sowie 5 258 989 beschrieben.

Daneben besteht die Technik des Strahldrehens, bei dem die Strahlung einzelner Emitter um 90° gedreht wird, um so eine Umordnung vorzunehmen bei der eine Anordnung der Strahlen in Richtung der Achse der besseren Strahlqualität erfolgt. Zu diesem Verfahren sind folgende Anordnungen bekannt: US 5 168 401, EP 0 484 276, DE 4 438 368. Allen Verfahren ist gemein, daß die Strahlung eines Diodenlasers nach dessen Kollimation in der Fast-Axis-Richtung, um 90° gedreht wird um eine Slow-Axis-Kollimation mit einer gemeinsamen Zylinderoptik vorzunehmen. In Abwandlung der genannten Verfahren ist auch eine durchgehende Linienquelle denkbar (z.B. die eines in Fast-Axis-Richtung kollimierten Diodenlasers hoher Belegungsdichte), deren Strahlprofil (Linie) aufgeteilt wird und in umgeordneter Form hinter dem optischen Element vorliegt.

Daneben besteht die Möglichkeit, ohne eine Drehung des Strahles eine Umordnung der Strahlung einzelner Emitter vorzunehmen, wobei durch z.B. durch den parallelen Versatz (Verschieben) mittels paralleler Spiegel eine Umordnung der Strahlung erreicht wird (WO 95/15510). Eine Anordnung, die sich ebenfalls der Technik des Umordnens bedient, ist in DE 195 00 53 und DE 19 5 44 488 beschrieben. Hierbei wird die Strahlung eines Diodenlaserbarrens in verschiedene Ebenen abgelenkt und dort einzeln kollimiert.

Die Nachteile des Standes der Technik lassen sich u.a. dahingehend zusammenfassen, daß bei fasergekoppelten Diodenlasern meist ein Strahl mit sehr unterschiedlichen Strahlqualitäten in beiden Achsrichtungen in die Faser eingekoppelt wird. Bei einer kreisrunden Faser bedeutet dies, daß in einer Achsrichtung die mögliche numerische Apertur oder der Faserdurchmesser nicht genutzt wird. Dies führt zu erheblichen Verlusten bei der Leistungsdichte, so daß in der Praxis eine Beschränkung auf ca. 10⁴ W/cm² erfolgt.

Bei den genannten bekannten Verfahren müssen weiterhin teilweise erhebliche Weglängenunterschiede kompensiert werden. Dies geschieht meist durch Korrekturprismen, die Fehler nur begrenzt ausgleichen können. Vielfachreflexionen stellen weiterhin erhöhte Anforderungen an Justagegenauigkeit, Fertigungstoleranzen sowie Bauteilstabilität (WO 95/15510). Reflektierende Optiken (z.B. aus Kupfer) verfügen über hohe Absorptionswerte.

Dokument DE 195 14 626 A offenbart eine Laseroptik gemäß dem Oberbegriff von Anspruch 1.

Aufgabe der Erfindung ist es, eine Laseroptik aufzuzeigen, die die vorgenannten Nachteile vermeidet und bei der Möglichkeit einer einfachen und preiswerten Fertigung eine Umformung eines Laserstrahls in der jeweils gewünschten Weise ermöglicht. Zur Lösung dieser Aufgabe ist eine Laseroptik entsprechend dem Patentanspruch 1 ausgebildet. Ein Diodenlaser ist entsprechend dem Patentanspruch 22 ausgebildet.

Unter "Plattenfächer" ist im Sinne der Erfindung ein vom Laserlicht durchstrahltes optisches Element zu verstehen, welches sich aus mehreren Platten oder plattenförmigen Elementen aus einem lichtleitenden Material, vorzugsweise Glas, zusammensetzt, die stapelartig aneinander anschließen und fächerartig gegen einander verdreht sind. Jede Platte oder jedes plattenförmige Element bildet an einander gegenüberliegenden Seiten eine Plattenschmalseite für den Lichteintritt oder -austritt und ist so ausgebildet, daß im Platten-Inneren im Bereich der Oberflächenseiten eine Totalreflexion erfolgt.

Unter "Oberflächenseiten" sind im Sinne der Erfindung jeweils die großen Plattenseiten zu verstehen. Unter "Schmalseiten" sind im Sinne der Erfindung die am Plattenrand zwischen den Oberflächenseiten gebildeten Seiten zu verstehen.

Der Plattenfächer kann durch Zusammensetzen aus einzelnen Platten oder plattenförmigen Elementen oder aber auch einstückig, beispielsweise als Formteil mit entsprechenden Zwischenschichten für die Totalreflexion, hergestellt sein.

Mit den im Lichtweg hintereinander angeordneten Umformelementen erfolgt bei der Laseroptik eine Auffächerung des Laserstrahles in in unterschiedlichen Ebenen angeordnete Teilstrahlen und ein anschließendes Übereinanderschieben dieser Teilstrahlen.

Die Erfindung wird im folgenden anhand der Figuren an Ausführungsbeispielen näher erläutert. Es zeigen:
- Fig. 1: in vereinfachter Darstellung einen Diodenlaser, bestehend aus einer eine Vielzahl von Laserelementen oder Laserchips aufweisenden Laserdiodenanordnung und einer im Strahlengang dieser Laserdiodenanordnung angeordneten von zwei Plattenfächern gebildeten optischen Anordnung zur Formung des Laserstrahls, wobei die Zeichenebene dieser Figur senkrecht zur aktiven Schicht der Diodenelemente liegt;
- Fig. 2: den Diodenlaser der Fig. 1, wobei die Zeichenebene dieser Figur parallel zu der aktiven Schicht der Diodenelement liegt;
- Fig. 3 und 4: in vereinfachter Darstellung die Ausbildung des Laserstrahls vor dem Umformen, beim Umformen und nach dem Umformen;
- Fig. 5 und 6: einen der optischen Plattenfächer in Seitenansicht sowie in Draufsicht;
- Fig. 7 und 8: einen Diodenlaser ähnlich dem Diodenlaser der Fig. 1 und 2, jedoch mit einer im Strahlengang nach den beiden Plattenfächern angeordneten Fokussieroptik bestehend aus einer Zylinderlinse und einer sphärischen Sammellinse, wobei die Zeichenebene der Fig. 7 senkrecht zur aktiven Schicht und die Zeichenebene der Fig. 8 parallel zur aktiven Schicht der Diodenelemente liegt;
- Fig. 9 und 10: einen Diodenlaser, bei dem die Laserdiodenanordnung von einer Vielzahl von Diodenelementen gebildet ist, die in mehreren Reihen senkrecht zur aktiven Schicht stapelartig übereinander vorgesehen sind, sowie mit einer Fokussieroptik im Strahlengang vor der von den beiden Plattenfächern gebildeten optischen Anordnung, wobei die Zeichenebene der Fig. 9 senkrecht zur aktiven Schicht der Diodenelemente und die Zeichenebene der Fig. 10 parallel zur aktiven Schicht der Diodenelemente liegt;
- Fig. 11 und 12: in ähnlicher Darstellung wie Fig. 1 und 2 eine weitere mögliche Ausführungsform, bei der im Strahlengang lediglich ein Plattenfächer und daran anschließend ein gestufter Spiegel (Treppenspiegel) vorgesehen ist.

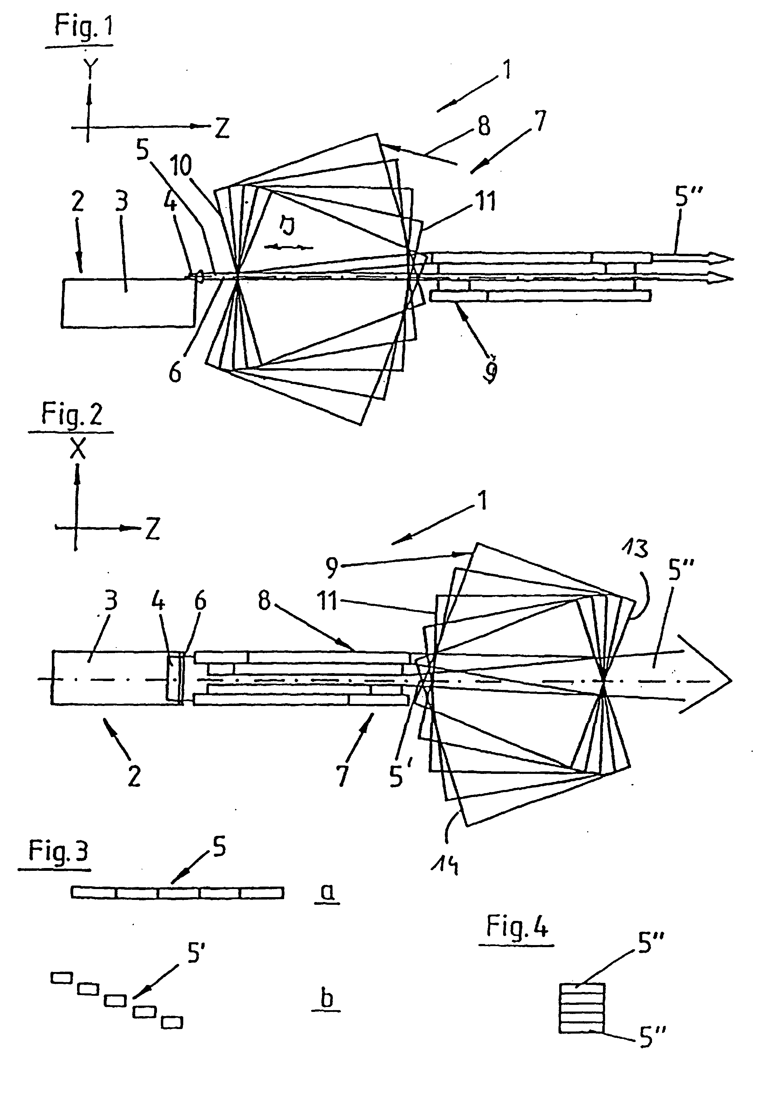

Der in den Figuren 1 und 2 dargestellte Diodenlaser 1 besteht im wesentlichen aus einer Laserdiodenanordnung 2, die an einem u.a. auch als Wärmesenke ausgebildeten Substrat 3 ein Laserbauelement 4 mit einer Vielzahl von Laserlicht aussendenden Emittern aufweist, die gleichsinnig orientiert sind und insbesondere auch mit ihren aktiven Schichten in einer gemeinsamen Ebene senkrecht zur Zeichenebene der Fig. 1 bzw. parallel zur Zeichenebene der Fig. 2 liegen, d.h. in einer X-Z-Ebene, die durch die in den Figuren angegebene X-Achse und Z-Achse definiert ist.

Im Strahlengang der von dem Laserbauelement 4 ausgehenden Laserstrahlung befindet sich ein Fast-Axis-Kollimator 6, der beispielsweise von einer mit ihrer Achse in der X-Achse liegenden Zylinderlinse gebildet ist und eine Kollimation der Laserstrahlung in der sog. Fast-Axis, d.h. in der Y-Achse und damit in der Y-Z-Ebene senkrecht zur aktiven Schicht wirkt, in der die Strahlung der Emitter des Laserbauelementes 4 die größere Divergenz aufweist. Nach dem Fast-Axis-Kollimator 6 steht die Laserstrahlung im wesentlichen als schmalbandige Strahlung zur Verfügung, wie dies in der Fig. 3 mit 5 angedeutet ist.

Auf den Fast-Axis-Kollimator 6 folgend ist im Strahlengang der Laserstrahlung eine optische Einrichtung 7 zur weiteren Formung des Laserstrahls vorgesehen, und zwar beispielsweise in der Weise, daß das Strahlung 5 (Fig. 3 - Position a) zunächst in Teilstrahlungen 5' in verschiedenen Ebenen parallel zur X-Z-Ebene zertrennt bzw. aufgefächert wird, die von Ebene zu Ebene auch in der X-Achse gegen einander versetzt sind (Fig. 3 - Position b), und diese Teilstrahlungen 5' dann diagonal übereinander geschoben werden, wie dies in der Fig. 4 mit 5" schematisch gezeigt ist.

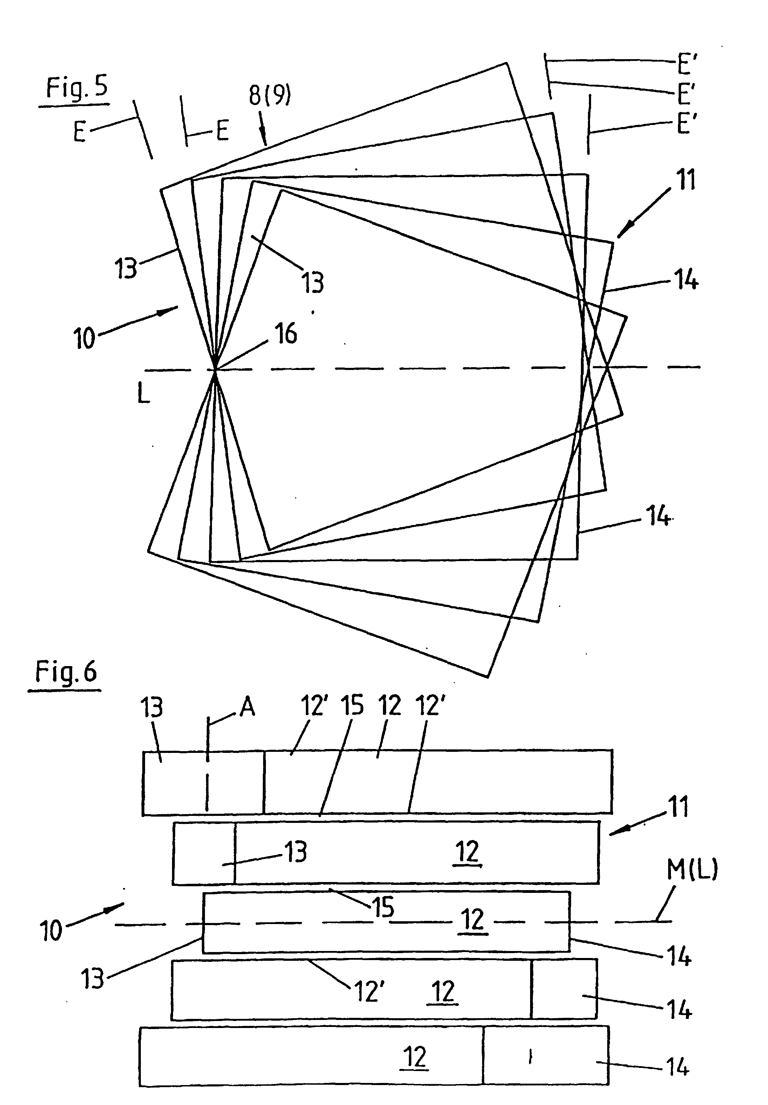

Die optische Einrichtung 7 besteht hierfür aus zwei Plattenfächern 8 und 9, die bei der dargestellten Ausführungsform identisch ausgebildet sind, allerdings um 90° um die Z-Achse gedreht beidseitig von einer die Z-Achse senkrecht schneidenden gedachten Mittelebene so angeordnet sind, daß beide Plattenfächer jeweils mit einer gleichartig ausgebildeten Fächerseite 10 von dieser Mittelebene wegweisen und mit einer gleichartig ausgebildeten Fächerseite 11 dieser Mittelebene zugewandt sind. Der Aufbau beispielsweise des Plattenfächers 8 ist in den Fig. 5 und 6 im Detail dargestellt. Der Plattenfächer 9 ist in der gleichen Weise ausgebildet, so daß die nachfolgende Beschreibung auch für diesen Plattenfächer gilt.

Der Plattenfächer 8 besteht aus mehreren dünnen Platten 12, die aus einem Licht leitenden Material, beispielsweise Glas hergestellt sind und bei der dargestellten Ausführugnsform jeweils einen quadratischen Zuschnitt aufweisen. Jede Platte 12 besitzt zwei plane Plattenschmalseiten 13 und 14, die die Seiten für den Eintritt und den Austritt der Laserstrahlen bilden und hierfür optisch hochwertig ausgebildet, d.h. poliert und mit einer Anti-Reflexionsschicht versehen sind. Die beiden Seiten 13 und 14 liegen sich an jeder Platte 12 gegenüber und sind bei der dargestellten Ausführungsform parallel zueinander angeordnet. Bei der Darstellung der Fig. 5 und 6 ist davon ausgegangen, daß der Plattenfächer 8 von insgesamt fünf Platten 12 gebildet ist. Theoretisch sind auch weniger oder mehr als fünf Platten 12 möglich.

Die Platten 12 schließen mit ihren Oberflächenseiten 12', an denen sie ebenfalls poliert sind, stapelartig aneinander an, wobei zwischen jeweils zwei benachbarten Platten 12 ein Spalt 15 vorgesehen ist, der von einem Medium, welches einen im Vergleich zum Material der Platten 12 kleineren optischen Brechungsindex aufweist, ausgefüllt ist. Der Spalt 15 ist beispielsweise ein Luftspalt, bevorzugt ist der jeweilige Spalt 15 aber mit einem die Platten 12 verbindenden Material, beispielsweise mit einem optischen Kitt ausgefüllt, wobei dieses Verbindungsmaterial wiederum einen im Vergleich zum Material der Platten 12 geringeren Brechungsindex aufweist, so daß eine Totalreflexion innerhalb der Platten 12 sichergestellt ist.

Die Platten 12 sind fächerartig gegeneinander versetzt. Bei der dargestellten Ausführungsform sind die Platten 12 hierfür um eine gemeinsame Fächerachse A gegen einander gedreht, wobei außerdem jeweils ein vorgegebener Bereich 16 der Plattenschmalseite 13, nämlich bei der dargestellten Ausführungsform die Mitte jeder Plattenschmalseite 13 jeder Platte 12 zusammen mit dem entsprechenden Bereichen 16 der übrigen Platten auf der gemeinsamen Achse A liegt, die senkrecht zu den Ebenen der Oberflächenseiten 12' der Platten 12 liegt und damit auch senkrecht zu einer parallel zu diesen Oberflächenseiten angeordneten, gedachten Mittelebene M des Plattenfächers 8. Um die Achse A bzw. um ihre Bereiche 16 sind die einzelnen Platten 12 derart fächerartig gegeneinander verdreht oder aufgefächert, daß die Ebenen E der Plattenschmalseiten 13 zweier benachbarter Platten sich in der Achse A schneiden und einen Winkel a miteinander einschließen, der in der Fig. 5 übertrieben groß dargestellt ist und beispielsweise in der Größenordnung von 1 - 5° liegt. Die mittlere Platte 12 liegt mit der Ebene E ihrer Plattenschmalseite 13 senkrecht zu einer Längserstreckung L oder optischen Achse des Plattenfächers 8. Die Gesamtheit der Plattenschmalseiten 13 aller Platten 12 bildet die Plattenfächerseite 10. Entsprechend der Anordnung der Plattenschmalseiten 13 sind auch die Plattenschmalseiten 14, die in ihrer Gesamtheit die Plattenfächerseite 11 bilden, so relativ zueinander angeordnet, daß die Ebenen E' zweier benachbarter Plattenseiten 14 wiederum den Winkel α miteinander einschließen. Die Ebenen E und E' der Plattenschmalseiten 13 und 14 liegen senkrecht zu den Ebenen der Oberflächenseiten 12'.

Der Plattenfächer 8 ist weiterhin so ausgebildet, daß die an die mittlere Platte 12 anschließenden Platten jeweils symmetrisch gedreht bzw. aufgefächert sind, d.h. für die für die Fig. 5 gewählte Darstellung die auf der einen Oberflächenseite 12' der mittleren Platte 12 vorgesehenen Platten 12 mit ihren Plattenschmalseiten 13 im Gegenuhrzeigersinn und die auf der anderen Oberflächenseite 12' der mittleren Platte 12 anschließenden Platten mit ihren Plattenschmalseiten 13 gegenüber der mittleren Platte im Uhrzeigersinn gedreht sind. Durch die dünne Ausbildung der Platten 12 und durch die Totalreflexion, die das Laserlicht innerhalb der Platten 12 an den Oberflächenseiten dieser Platten erfährt, bilden die Platten Licht- bzw. Wellen-Leiter für das Laserlicht.

Die Breite des jeweiligen Spaltes 15 ist möglichst gering, aber ausreichend groß gewählt (z.B. einige 1/100 mm), um sicherzustellen, daß auch bei einer leichten Verwölbungen einer oder mehrerer Platten 12 ein direkter Berührungskontakt zwischen zwei benachbarten Platten 12 nicht entsteht und somit Strahlungsverluste vermieden werden, die an derartigen Berührungsstellen auftreten und zur Reduzierung der Effizienz des Systems führen könnten.

Der Plattenfächer 8 ist bei dem Diodenlaser 1 derart angeordnet, daß er mit seiner Längsachse L in der Z-Achse liegt und die Mittelachse M in der Y-Z-Ebene, wobei die Plattenfächerseite 10 der Laserdiodenanordnung 2 zugewandt ist, der Laserstrahl 5 also an der Plattenfächerseite 10 in diesen Plattenfächer eintritt. Der Plattenfächer 9 ist mit seiner Längsachse L, die senkrecht zur Plattenschmalseite 13 der mittleren Platte 12 liegt und die Achse A senkrecht schneidet ebenfalls in der Z-Achse angeordnet, und zwar achsgleich mit der Achse L des Plattenfächers 8, wobei die Plattenfächerseite 11 des Plattenfächers 9 der Plattenfächerseite 11 des Plattenfächers 8 zugewandt ist. Die Mittelebene M des Plattenfächers 9 liegt in der X-Z-Ebene, so daß der Plattenfächer 9 gegenüber dem Plattenfächer 8 um 90° um die Z-Achse gedreht wird.

Der durch den Fast-Axis-Kollimator 6 kollimierte Laserstrahl 5 trifft auf die Plattenfächerseite 13 auf, und zwar im Bereich der Achse A bzw. der Längsachse L.

Durch die unterschiedliche Neigung der Plattenschmalseiten 13 und der Plattenseiten 14 wird der eintretende Laserstrahl 5 in die verschiedenen Teilstrahlen 5' aufgeteilt, die parallel oder im wesentlichen parallel zur Z-Achse an den Plattenseiten 14 aus dem Plattenfächer 8 austreten, wobei die Teilstrahlen 5' bedingt durch die Brechung an den Plattenschmalseiten 13 und 14 in unterschiedlichen Ebenen parallel zur X-Z-Ebene angeordnet sind. Es versteht sich, daß die Breite des Plattenfächers 8 in Richtung der Achse A und damit in Richtung der X-Achse gleich der Breite gewählt ist, die die auftreffende Strahlung 5 aufweist. Durch die Totalreflexion in den Platten 12 des Plattenfächers 8 erfährt die Strahlung in Richtung der Slow-Axis (X-Achse) keine Aufweitung, sondern jeder Teilstrahl 5' tritt mit einem Strahldurchmesser aus, der in dieser Achse gleich der Dicke einer Platte 12 ist.

Die einzelnen Teilstrahlen 5' treten dann jeweils an einer Plattenseite 14 in den Plattenfächer 9 ein. Durch die Brechung an den Plattenschmalseiten 13 und 14 treten sämtliche Teilstrahlen 5' an den Plattenschmalseiten 13 der Platten 12 des Plattenfächers 9 aus, und zwar im Bereich der dort parallel zur Y-Achse liegenden Achse A, so daß die Teilstrahlen 5' diagonal verschoben übereinander angeordnet sind, wie dies in der Fig. 4 dargestellt ist.

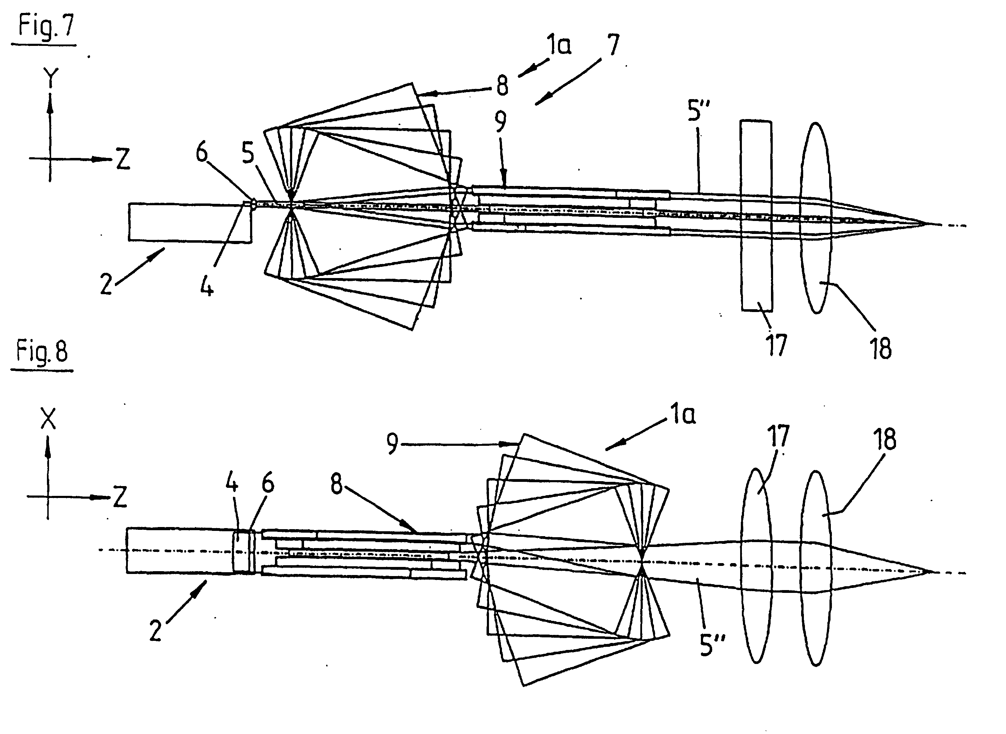

Die Fig. 7 und 8 zeigen einen Diodenlaser 1a, der sich von dem Diodenlaser 1 lediglich dadurch unterscheidet, daß im Strahlengang nach der optischen Anordnung 7 ein Slow-Axis-Kollimator 17 in Form einer Zylinderlinse vorgesehen ist, die mit ihrer Achse parallel zur Y-Achse angeordnet ist. Durch diesen Kollimator 17 wird die Divergenz, die die Teilstrahlen 5' in der Slow-Axis, d.h. in der X-Achse aufweisen, korrigiert, so daß anschließend mehrere, in Richtung der Y-Achse übereinander angeordnete kollimierte Teilstrahlen 5" vorliegen, die mittels einer Fokussieroptik, d.h. mittels der sphärischen Sammellinse 18 fokussiert werden.

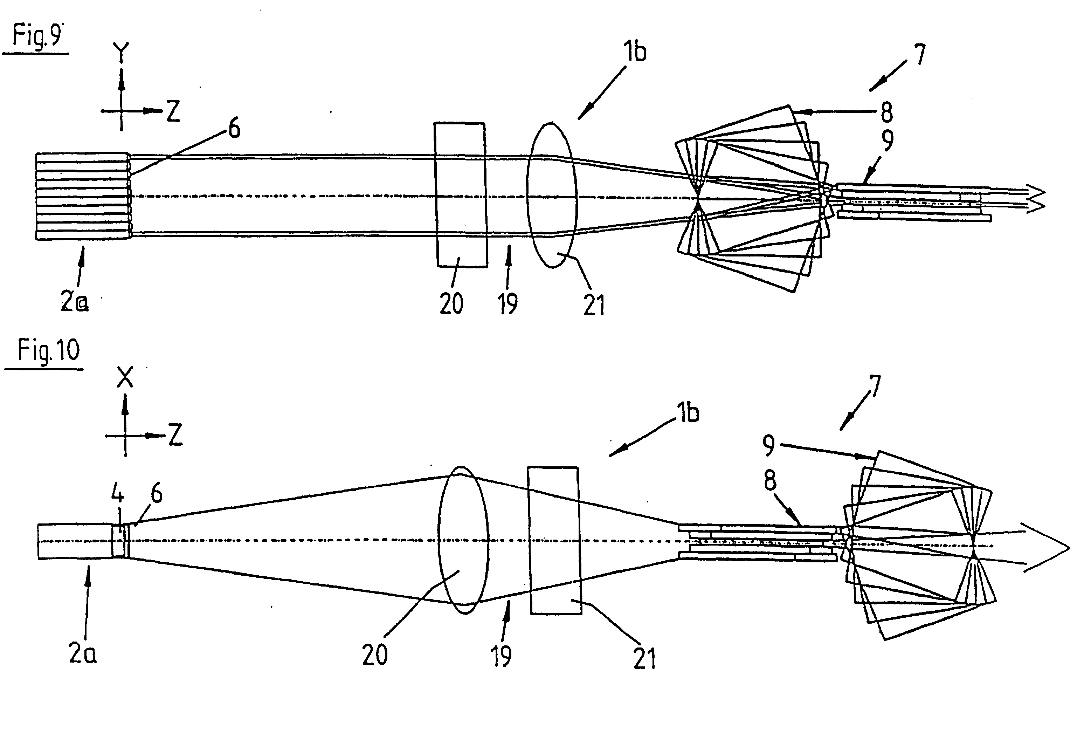

Die Fig. 9 und 10 zeigen einen Diodenlaser 1b, der sich vom Diodenlaser 1 dadurch unterscheidet, daß anstelle der Laserdiodenanordnung 2, die lediglich in einer X-Z-Ebene mehrere. Emitter nebeneinander aufweist, einen Diodenlaser 2a verwendet, der in mehreren X-Z-Ebenen übereinander eine Vielzahl von Laserbauelementen 4 mit jeweils einer Vielzahl von Emittern besitzt,die mit ihrer aktiven Schicht in dieser gemeinsamen Ebene angeordnet sind. Jeder X-Z-Ebene ist ein eigener Fast-Axis-Kollimator 6 zugeordnet. Im Strahlengang befindet sich nach diesen Fast-Axis-Kollimatoren 6 eine optische Anordnung 19, mit der die Laserstrahlung 5 auf den ersten Plattenfächer 8 fokussiert wird. Diese optische Anordnung 19 besteht aus einer Zylinderlinse 20, die mit ihrer Achse parallel zur Y-Achse angeordnet ist sowie aus einer weiteren Zylinderlinse 21, die mit ihrer Achse parallel zur X-Achse angeordnet ist. Durch die optische Anordnung 19 ist auch eine Stapelung von Laserbauteilen 4 möglich, obwohl dadurch der Laserstrahl 5 nach den Fast-Axis-Kollimatoren 6 in Richtung der Y-Achse eine relativ große Höhe besitzt. Eine derart große Strahlenhöhe würde insbesondere bei dem zweiten Plattenfächer 9 eine große Bauhöhe, d.h. eine Vielzahl von Platten 12 bedeuten, aber auch bedeuten, daß die aus dem zweiten Plattenfächer 9 austretende, von den Teilstrahlen 5' gebildete Laserstrahlung in Richtung Y-Achse ebenfalls eine große Höhe aufweist, die für die Weiterverarbeitung des Strahles eine aufwendige Optik erfordert. Durch die Fokussierung des Strahles 5 mit Hilfe der optischen Einrichtung 19 auf den ersten Plattenfächer 8 wird dies vermieden.

Weiterhin ist es auch möglich, an den Oberflächenseiten der Platten 12 metallische Spiegelschichten aufzubringen, um so die Totalreflexion innerhalb der Platten 12 zu gewährleisten.

Bei dem Diodenlaser 1b der Fig. 9 und 10 ist es von Vorteil, wenn die Teilstrahlen 5' beim Eintritt in den Plattenfächer 9 möglichst klein gehalten sind. Ideal wäre eine Anordnung, bei der der von der optischen Anordnung 19 erzeugte Fokus der Laserdiodenanordnung 2a nicht in einem gemeinsamen Punkt liegt, sondern in der Fastund Slow-Axis-Richtung verschiedene Fokuspunkte aufweist. Der Strahl der stapelartigen Laserdiodenanordnung 2a weist in diesem Fall dann einen Astigmatismus auf. Die einzelnen Foki sollen dabei folgendermaßen angeordnet sein:
- Fokus in Slow-Axis-Richtung (in Richtung der X-Achse) auf der Eintrittsseite des Plattenfächers 8;
- Fokus in der Fast-Axis-Richtung (Richtung der Y-Achse) auf der Eintrittsseite des Plattenfächers 9.

Bei dieser Fokusanordnung wird eine Minimierung der Dicken der Platten 12 in den beiden Plattenfächern 8 und 9 erreicht. Bevorzugt ist die Ausbildung so getroffen, daß die Divergenz vor dem jeweiligen Plattenfächer in Richtung der Fast-Axis (Y-Achse) im fokussierten Bereich kleiner ist (etwa um die Faktor der Plattenzahl) als in der Richtung der Slow-Axis (X-Achse), um so auf eine annähernd gleiche Strahlenqualität in beiden Achsrichtungen zu kommen.

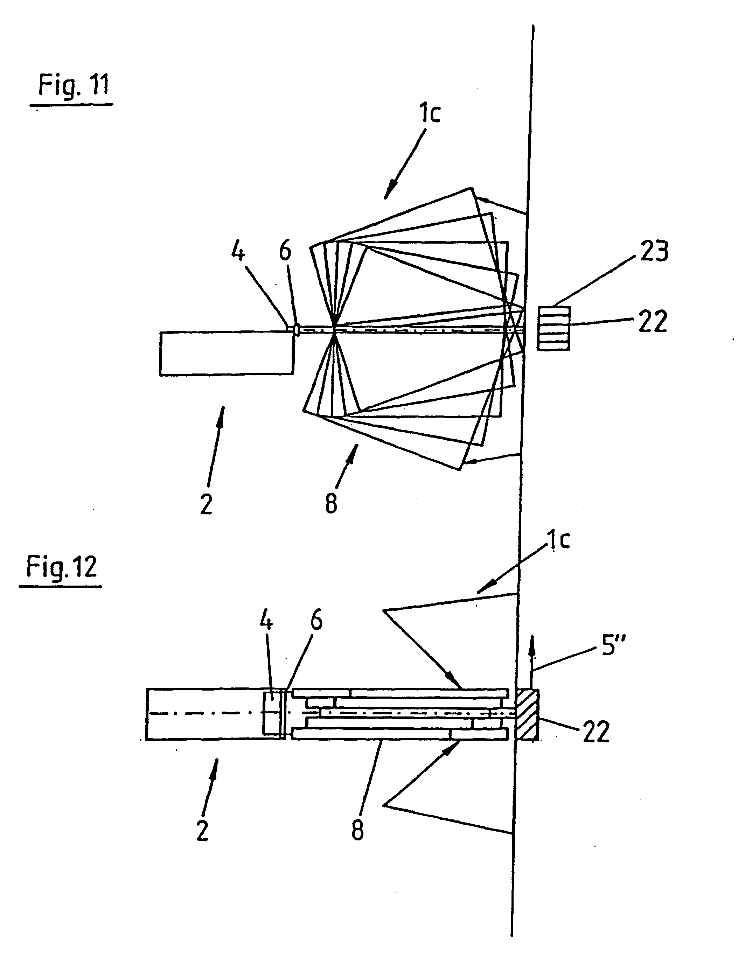

Die Fig. 11 und 12 zeigen als weitere Ausführungsform einen Diodenlaser 1c, der sich von dem Diodenlaser 1 der Fig. 1 und 2 nur dadurch unterscheidet, daß anstelle des im Strahlengang zweiten Plattenfächers 9 zum diagonalen Zusammenschieben des Strahlenbündels der Teilstrahlen 5' (Position b der Fig. 3) in das Strahlenbündel der Teilstrahlen 5" (fig. 4) ein sog. Treppenspiegel 22 vorgesehen ist. Dieser besitzt eine Vielzahl von Spiegelflächen 23, die derart treppenartig in der gegeneinander versetzt sind, daß durch Reflexion an den Spiegelflächen das Umformen des Strahlenbündels der Teilstrahlen 5' in das Strahlenbündel der Teilstrahlen 5" erfolgt.

Die Erfindung wurde voranstehend an Ausführungsbeispielen beschrieben. Es versteht sich, daß zahlreiche Änderungen sowie Abwandlungen möglich sind, die innerhalb des Schutzumfangs der Ansprüche liegen. So ist es beispielsweise auch möglich, die Platten 12 zusätzlich an ihren Oberflächenseiten mit einem Material zu beschichten, welches den im Vergleich zum Material der Platten 12 geringeren optischen Brechungsindex aufweist, um so den Wellenleitereffekt bzw. die Totalreflexion innerhalb der Platten zu verbessern. Weiterhin besteht selbstverständlich die Möglichkeit, auch bei den Diodenlasern 1a und 1b anstelle des Plattenfächers 9 den Treppenspiegel 22 zu verwenden.

Vorstehend wurde davon ausgegangen, daß die Platten 12 der Plattenfächer 8 und 9 jeweils um eine gemeinsame Fächerachse A gegeneinander verdreht sind, die in der Ebene der Plattenschmalseite 13 liegt. Auch hier sind andere Ausführungen denkbar, beispielsweise können die Platten der Plattenfächer auch um mehrere parallele Achsen A gegeneinander fächerartig verdreht sein, und zwar jeweils zwei Platten um eine Achse. Weiterhin kann die Lage der Achse bzw. Achsen auch anders gewählt sein als vorstehend beschrieben. Die Achse oder Achsen können auch außerhalb der Ebenen der Plattenseiten 13 liegen.

So wurde bei der vorstehenden Beschreibung zur Vereinfachung des Verständnisses davon ausgegangen, daß bei dem im Strahlengang zweiten Plattenfächer 9 die Plattenseiten 13 (Strahleintrittsseite) sämtlicher Platten 12 um eine gemeinsame Achse A (entsprechend dem Punkt 16) gegeneinander verdreht sind und sich die Ebenen dieser Plattenseiten 13 in der gemeinsamen Achse A schneiden. Dies ist tatsächlich beim zweiten Plattenfächer 9 nicht erforderlich. Erforderlich ist, daß die Ebenen der Plattenseiten 13 die vorgegebenen Winkel miteinander einschließen. Die Platten 13 können aber in der Ebene ihrer Oberflächenseiten, d.h. bei der für die Figur 2 gewählten Darstellung in der X-Z-Ebene gegeneinander verschoben sein.

Es ist weiterhin möglich, die Platten 12 des ersten Plattenfächers 8 in der Ebene ihrer Oberflächenseiten, d.h. bei der für die Figur 1 dargestellten Ausführungsform in der Y-Z-Ebene, und dabei insbesondere in der Strahlachse (Z-Achse der Figuren 1 und 2 - Doppelpfeil J der Fig. 1) so durch verschieben relativ zueinander einzustellen bzw. zu justieren, daß sich für die Strahlen durch sämtliche Platten 12 bis zur Fokussierung gleiche Weglängen bzw. Laufzeiten ergeben, um so eine optimale Strahlfokussierung zu erreichen. Nach dieser Justage werden die Platten 12 des Plattenfächers 8 dann fest miteinander verbunden. In diesem Fall schneiden sich dann die Ebenen sämtlicher Plattenseiten 13 des ersten Plattenfächers 8 ebenfalls nicht in der gemeinsamen Achse A (entsprechend Punkt 16) sondern in mehreren parallelen Achsen.

### Bezugszeichenliste

- 1, 1a, 1b, 1c: Diodenlaser
- 2, 2a: Laserdiodenanordnung
- 3: Substrat
- 4: Laserbauelement
- 5: bandförmiger Laserstrahl
- 5': Teilstrahl
- 6: Fast-Axis-Kollimator
- 7: optische Anordnung
- 8, 9: Plattenfächer
- 10, 11: Plattenfächerseite
- 12: Platte
- 13, 14: Plattenseite
- 15: Spalt
- 16: Punkt
- 17: Slow-Axis-Kollimator
- 18: Sammellinse
- 19: Fokussieroptik
- 20, 21: Zylinderlinse
- 22: Treppenspiegel
- 23: Spiegelfläche

## Patentansprüche

1. Laseroptik zum Umformen wenigstens eines Laserstrahls, der einen sich in einer ersten X-Achsrichtung senkrecht zur Z-Strahlachse erstreckenden linien- oder bandförmigen Querschnitt aufweist, mit wenigstens zwei im Strahlengang aufeinander folgend angeordneten optischen Umformelementen (8, 9, 22), von denen wenigstens eines ein vom Laserstrahl durchstrahltes Element ist und die eine optischen Anordnung (7) bilden,
- in der ein Auffächern des wenigstens einen Laserstrahls (5) in mehrere parallele Teilstrahlen jeweils in einer Y-Z-Ebene senkrecht zur ersten X-Achse, wobei die parallelen Teilstrahlen (5') sowohl in der ersten X-Achsrichtung als auch in einer zweiten Y-Achsrichtung, die senkrecht zur Z-Strahlachse sowie senkrecht zur ersten X-Achse liegt, gegeneinander versetzt sind,
- in der anschließend ein Zusammenführen der aufgefächerten Teilstrahlen (5') erfolgt, und in der das zweite optische Umformelement ein Verschieben der im ersten optischen Umformelement gebildeten Teilstrahlen (5') jeweils in einer X-Z-Ebene parallel zu der ersten X-Achse derart bewirkt, daß bei dem aus dem zweiten optischen Element (9, 22) austretenden Laserstrahl die parallelen Teilstrahlen (5") übereinandergeschoben und nur oder im wesentlichen nur noch in der zweiten Y-Achse gegeneinander versetzt sind,
**dadurch gekennzeichnet,**
**daß** wenigstens ein optisches Umformelement ein Plattenfächer (8) ist, der aus mehreren Platten (12) aus einem lichtleitenden Material besteht, die in Richtung senkrecht zu ihren Oberflächenseiten versetzt sind und in denen eine Führung des Strahls durch Totalreflexion erfolgt, und bei dem
- die Platten (12) jeweils eine erste plane Plattenschmalseite (13) und dieser gegenüberliegend eine zweite plane Plattenschmalseite (14) bilden,
- die erste Plattenschmalseite (13) und die zweite Plattenschmalseite (14) jeder Platte parallel zueinander liegen,
- die Plattenschmalseiten (13, 14) fächerartig derart gegeneinander verdreht sind, daß die erste Plattenschmalseite (13) jeder Platte (12) in einer Ebene (E) liegt, die mit der Ebene der ersten Plattenschmalseite (13) jeder benachbarten Platte (12) einen Winkel α einschließt,
- die ersten Plattenschmalseiten (13) in ihrer Gesamtheit eine erste Plattenfächerseite (10) und die zweiten Plattenschmalseiten (14) in ihrer Gesamtheit eine zweite Plattenfächerseite (11) jeweils für den Eintritt oder Austritt des den Plattenfächer durchstrahlenden, wenigstens einen Laserstrahls bilden,
- die Ebenen (E) der Plattenschmalseiten (13, 14) sowie die Fächerachse (A) senkrecht zu den Oberflächenseiten (12') der Platten (12) liegen.

2. Laseroptik nach Anspruch 1, **dadurch gekennzeichnet, daß** das erste optische Umformelement das Auffächern des wenigstens einen Laserstrahls (5) in mehrere parallele Teilstrahlen jeweils in einerY-Z-Ebene senkrecht zur ersten X-Achse bewirkt.

3. Laseroptik nach Anspruch 1 oder 2, **dadurch gekennzeichnet, daß** die Platten (12) senkrecht zu ihren Oberflächenseiten stapelartig aufeinanderfolgend vorgesehen sind.

4. Laseroptik nach einem der vorhergehenden Ansprüche, **dadurch gekennzeichnet, daß** die Ebenen (E) der ersten Plattenschmalseiten (13) um wenigstens eine Fächerachse (A) gegeneinander verdreht sind.

5. Laseroptik nach Anspruch 4, **dadurch gekennzeichnet, daß** die Ebenen der ersten Plattenschmalseiten um eine gemeinsame Fächerachse (A) gegeneinander verdreht sind.

6. Laseroptik nach Anspruch 4, **dadurch gekennzeichnet, daß** die Ebenen (E) der ersten Plattenschmalseiten (13) um wenigstens zwei unterschiedliche Fächerachsen (A) gegeneinander versetzt oder verdreht sind.

7. Laseroptik nach einem der vorhergehenden Ansprüche, **dadurch gekennzeichnet, daß** das erste Umformelement ein Plattenfächer (8) ist, der vorzugsweise mit den Ebenen der Oberflächenseiten (12') seiner Platten (12) parallel zu einer von der Z-Strahlachse und der zweiten Y-Achse definierten Y-Z-Ebene angeordnet ist und mit seiner Fächerachse (A) parallel zur ersten X-Achse liegt.

8. Laseroptik nach einem der vorhergehenden Ansprüche, **dadurch gekennzeichnet, daß** das zweite optische Umformelement ein Plattenfächer (9) ist, der vorzugsweise mit den Ebenen der Oberflächenseiten (12') seiner Platten (12) parallel zu einer von der Z-Strahlachse und der ersten X-Achse definierten X-Z-Ebene angeordnet ist und mit seiner Fächerachse (A) parallel zur zweiten Y-Achse liegt.

9. Laseroptik nach Anspruch 7 oder 8, **dadurch gekennzeichnet, daß** die beiden, das erste und zweite optische Umformelement bildenden Plattenfächer (8, 9) um die Z-Strahlachse um 90° gegeneinander gedreht angeordnet sind, so daß der das erste optische Umformelement bildende Plattenfächer (8) mit den Ebenen der Oberflächenseiten (12') seiner Platten senkrecht zu den Ebenen der Oberflächenseiten der Platten des zweiten Plattenfächers (9) liegt, und daß vorzugsweise die beiden Plattenfächer (8, 9) mit ihrer zweiten Plattenfächerseite (11) einander zugewandt sind.

10. Laseroptik nach einem der vorhergehenden Ansprüche, **dadurch gekennzeichnet, daß** in den Platten (12) des Plattenfächers (8, 9), vorzugsweise in den Platten (12) des das erste Umformelement bildenden Plattenfächers (8) die Führung des Strahls durch Totalreflektion erfolgt.

11. Laseroptik nach einem der vorhergehenden Ansprüche, **dadurch gekennzeichnet, daß** die wenigstens eine Fächerachse (A) die erste Plattenschmalseite (13) wenigstens einer Platte (12) berührt oder in der Ebene dieser Plattenschmalseite liegt.

12. Laseroptik nach einem der vorhergehenden Ansprüche, **dadurch gekennzeichnet, daß** bei dem Plattenfächer (8, 9) die Ebenen (E) der ersten Plattenschmalseite jeweils den gleichen Winkel miteinander einschließen.

13. Laseroptik nach einem der vorhergehenden Ansprüche, **dadurch gekennzeichnet, daß** bei dem Plattenfächer (8, 9) ausgehend von einer außen liegenden Platte (12) die ersten Plattenschmalseiten (13) der auschließenden Platten oder deren Projektionen auf eine parallel zu den Oberflächenseiten (12') liegenden Ebene jeweils gleichsinnig gegeneinander verdreht sind.

14. Laseroptik nach einem der vorhergehenden Ansprüche, **dadurch gekennzeichnet, daß** zur Erzielung einer Totalreflexion innerhalb jeder Platte (12) an den Oberflächenseiten dieser Platte an jeder Oberflächenseite anschließend ein Medium vorgesehen ist, welches einen im Vergleich zum Material der Platte kleineren Brechungsindex aufweist,
wobei beispielsweise zwischen zwei benachbarten Platten (12) ein Kleber oder Kitt mit einem im Vergleich zum Material der Platten kleineren optischen Brechungsindex vorgesehen ist, und/oder
wobei beispielsweise zwischen zwei benachbarten Platten ein Luftspalt vorgesehen ist, und/oder
wobei beispielsweise die Platten (12) an ihren Oberflächenseiten (12') verspiegelt sind.

15. Laseroptik nach einem der vorhergehenden Ansprüche, **dadurch gekennzeichnet, daß** bei Verwendung wenigstens einer Laserdiodenanordnung (2, 2a) als Strahlungsquelle, die wenigstens ein Laser-Bauelement (4) mit mehreren in einer ersten X-Achsrichtung gegeneinander versetzten, Laserlicht aussendenden Emittern aufweist, die mit ihrer aktiven Schicht in einer gemeinsamen, die erste X-Achsrichtung einschließenden X-Z-Ebene angeordnet sind, der das erste Umformelement bildende Plattenfächer (8, 9) mit den Ebenen der Oberflächenseiten (12') seiner Platten (12) senkrecht zur Ebene der aktiven Schicht liegt.

16. Laseroptik nach einem der vorhergehenden Ansprüche, **dadurch gekennzeichnet, daß** bei Verwendung wenigstens einer Laserdiodenanordnung (2, 2a) als Strahlungsquelle, die wenigstens ein Laser-Bauelement (4) mit mehreren in einer ersten X-Achsrichtung gegeneinander versetzten, Laserlicht aussendenden Emittern aufweist, die mit ihrer aktiven Schicht in einer gemeinsamen, die erste X-Achsrichtung einschließenden X-Z-Ebene angeordnet sind, der das zweite Umformelement bildende Plattenfächer (8, 9) mit den Ebenen der Oberflächenseiten (12') seiner Platten (12) parallel zur Ebene der aktiven Schicht liegt.

17. Laseroptik nach Anspruch 14 und 15, **dadurch gekennzeichnet, daß** bei wenigstens zwei im Strahlengang hintereinander angeordneten Plattenfächern (8, 9) der im Strahlengang auf die Laserdiodenanordnung (2, 2a) folgende erste Plattenfächer (8) mit den Ebenen der Oberflächenseiten (12') seiner Platten (12) senkrecht zur Ebene der aktiven Schicht und der im Strahlengang auf die Laserdiodenanordnung (2, 2a) folgende zweite Plattenfächer (9) mit den Ebenen der Oberflächenseiten (12') seiner Platten (12) parallel zur Ebene der aktiven Schicht angeordnet ist.

18. Laseroptik nach einem der vorhergehenden Ansprüche, **dadurch gekennzeichnet, daß** auf die von den Umformelementen (8, 9) gebildete optische Anordnung im Strahlengang wenigstens eine weitere, den Strahl formende optische Anordnung, beispielsweise eine Fokussieranordnung und/oder ein Kollimator (17) vorgesehen ist.

19. Laseroptik nach einem der vorhergehenden Ansprüche, **dadurch gekennzeichnet, daß** im Strahlengang vor der von den Umformelementen (8, 9) gebildeten optischen Anordnung (7) eine weitere, den Strahl formende Anordnung, beispielsweise wenigstens ein Kollimator (6) und/oder eine Fokussiereinrichtung (19) vorgesehen ist.

20. Laseroptik nach einem der vorhergehenden Ansprüche, **dadurch gekennzeichnet, daß** bei Verwendung einer Laserdiodenanordnung (2a) mit in mehreren Ebenen in einer Y-Achsrichtung senkrecht zur aktiven Schicht übereinander angeordneten Laser-Bauelementen (4) zwischen der Laserdiodenanordnung (2a) und der von den Umformelementen (8, 9) gebildeten optische Anordnung (7) eine den Laserstrahl fokussierende Fokussierungsoptik (19) vorgesehen ist,
wobei beispielsweise eine den Laserstrahl im Bereich der Umformelemente (8, 9) bzw. im Bereich der von diesen Elementen gebildeten optischen Anordnung (7) fokussierende Fokussieroptik (19) vorgesehen ist, und/oder
wobei beispielsweise eine einen Astigmatismus aufweisende Fokussieroptik (19) vorgesehen ist, die den Laserstrahl in eine erste Ebene, beispielsweise in der von der ersten X-Achse und der Z-Strahlachse definierten X-Z-Ebene und an einem in Z-Strahlrichtung folgenden Bereich in einer senkrecht zu der ersten Ebene liegenden zweiten Ebene, beispielsweise in der von der zweiten Y-Achse und Z-Strahlachse definierten Y-Z-Ebene fokussiert, und/oder
wobei beispielsweise Fokussieroptik vorgesehen ist, die den Laserstrahl in der ersten X-Z-Ebene auf die Eintrittsfläche des ersten Umformelementes (8) und in der zweiten Y-Z-Ebene auf die Eintrittsfläche des zweiten Umformelementes (9) fokussiert.

21. Laseroptik nach einem der vorhergehenden Ansprüche, **dadurch gekennzeichnet, daß** wenigstens bei einem der als Plattenfächer ausgeführten Umformelemente die Platten (12) zur Erzielung gleicher Laufzeiten oder Weglängen der durch die verschiedenen Platten geführten Strahlen wenigstens in der Strahlrichtung relativ zueinander justiert oder eingestellt sind.

22. Diodenlaser mit wenigstens einer Laserdiodenanordnung (2, 2a) als Strahlungsquelle, die wenigstens ein Laser-Bauelement (4) mit mehreren in einer ersten X-Achsrichtung gegeneinander versetzten, Laserlicht aussendenden Emittern aufweist, die mit ihrer aktiven Schicht in einer gemeinsamen, die erste X-Achsrichtung einschließenden X-Z-Ebene angeordnet sind, sowie mit einer Laseroptik mit wenigstens einer im gemeinsamen Laserstrahl (5) der Emitter angeordneten optischen Anordnung (7) zum Formen des Laserstrahls, **dadurch gekennzeichnet, daß** die - Laseroptik des Diodenlasers nach einem der Ansprüche 1 - 21 ausgebildet ist.

## Claims

1. Laser lens for deforming at least one laser beam, which has a line-shaped or band-shaped cross section that extends in a first X axis direction perpendicular to the Z beam axis, with at least two optical deformation elements (8, 9, 22) arranged following on from one another in the beam path, at least one of which is an element through which the laser beam passes, and which form an optical arrangement (7),
- in which a fanning out of the at least one laser beam (5) into several parallel partial beams respectively in a Y-Z plane perpendicular to the first X axis,
wherein the parallel partial beams (5'), both in the first X axis direction as well as in a second Y axis which lies perpendicular to the Z beam axis as well as perpendicular to the first X axis, are offset against one another,
- in which subsequently the fanned-out partial beams (5') are brought together,
- and in which the second optical deformation element effects a displacement of the partial beams (5') formed in the first optical deformation element respectively in an X-Z plane parallel to the first X axis, in such a way that in the case of the laser beam emerging from the second optical element (9, 22), the parallel partial beams (5") are pushed over one another and are offset against one another only, or essentially now only, in the second Y axis,
**characterised in that**
at least one optical deformation element is a plate fan (8) which comprises several plates (12) of a light-conductive material which are offset in a direction perpendicular to their surface faces, and in which guidance of the bean takes place through total reflection, and in which
- the plates (12) in each case form a first, planar narrow side (13) of a plate, and opposite this a second, planar narrow side (14) of a plate,
- the first narrow side (13) and the second narrow side (14) of each plate lie parallel to one another,
- the narrow sides (13, 14) of the plate are rotated against one another in a fan-like manner in such a way that the first narrow side (13) of each plate (12) lies in a plane (E) which encloses an angle α with the plane of the first narrow side (13) of each adjacent plate (12),
- the first narrow plate sides (13), in their entirety, form a first plate fan side (10) and the second narrow plate sides (14), in their entirety, form a second plate fan side (11), respectively for the entry or exit of the at least one laser beam that passes through the plate fan,
- the planes (E) of the narrow plate sides (13, 14) as well as the fan axis (A) lie perpendicular to the surface faces (12') of the plates (12).

2. Laser lens in accordance with claim 1, **characterised in that** the first optical deformation element effects the fanning out of the at least one laser beam (5) into several parallel partial beams respectively in a Y-Z plane perpendicular to the first X axis.

3. Laser lens in accordance with claim 1 or 2, **characterised in that** the plates (12) are provided following on from one another in the manner of a stack, perpendicular to their surface faces.

4. Laser lens in accordance with one of the preceding claims, **characterised in that** the planes (E) of the first narrow plate sides (13) are rotated against one another around at least one fan axis (A).

5. Laser lens in accordance with claim 4, **characterised in that** the planes of the first narrow plate sides are rotated against one another around a common fan axis (A).

6. Laser lens in accordance with claim 4, **characterised in that** the planes (E) of the first narrow sides (13) of the plates are offset or rotated against one another around at least two different fan axes (A).

7. Laser lens in accordance with one of the preceding claims, **characterised in that** the first deformation element is a plate fan (8) which is preferably arranged with the planes of the surface faces (12') of its plates (12) parallel to a Y-Z plane defined by the Z beam axis and the second Y axis, and lies with its fan axis (A) parallel to the first X axis.

8. Laser lens in accordance with one of the preceding claims, **characterised in that** the second optical deformation element is a plate fan (9) which is preferably arranged with the planes of the surface faces (12') of its plates (12) parallel to an X-Z plane defined by the Z beam axis and the first X axis, and lies with its fan axis (A) parallel to the second Y axis.

9. Laser lens in accordance with claim 7 or 8, **characterised in that** the two plate fans (8, 9) that form the first and second optical deformation elements are arranged rotated against one another by 90° around the Z beam axis, so that the plate fan (8) which forms the first optical deformation element lies with the planes of the surface faces (12') of its plates perpendicular to the planes of the surface faces of the plates of the second plate fan (9), and that preferably the two plate fans (8, 9) face each other with their second plate fan side (11).

10. Laser lens in accordance with one of the preceding claims, **characterised in that** in the plates (12) of the plate fan (8; 9), preferably in the plates (12) of the plate fan (8) which forms the first deformation element, guidance of the beam takes place through total reflection

11. Laser lens in accordance with one of the preceding claims, **characterised in that** the at least one fan axis (A) touches the first narrow side (13) of at least one plate (12), or lies in the plane of this narrow plate side.

12. Laser lens in accordance with one of the preceding claims, **characterised in that** in the case of the plate fans (8, 9), the planes (E) of the first narrow plate side in each case enclose the same angle with one another.

13. Laser lens in accordance with one of the preceding claims, **characterised in that** in the case of the plate fans (8, 9), starting from a plate (12) lying outside, the first narrow sides (13) of the adjoining plates, or their projections, are respectively rotated in the same direction against one another on a plane lying parallel to the surface faces (12').

14. Laser lens in accordance with one of the preceding claims, **characterised in that** in order to achieve total reflection, within each plate (12) on the surface faces of this plate, a medium is subsequently provided on each surface face which has a lower refractive index in comparison to the material of the plate,
wherein for example an adhesive or cement with a lower refractive index in comparison to the material of the plates is provided between two adjacent plates, and/or
wherein an air gap is provided for example between two adjacent plates, and/or
wherein for example the plates (12) are metal-coated on their surface faces (12').

15. Laser lens in accordance with one of the preceding claims, **characterised in that** where at least one laser diode arrangement (2, 2a) is used as the radiation source, which has at least one laser component (4) with several laser-light-emitting emitters that are offset against one another in a first X axis direction, which are arranged with their active layer in a common X-Z plane that encloses the first X axis direction, the plate fan (8, 9) that forms the first deformation element lies with the planes of the surface faces (12') of its plates (12) perpendicular to the plane of the active layer.

16. Laser lens in accordance with one of the preceding claims, **characterised in that** where at least one laser diode arrangement (2, 2a) is used as the radiation source, which has at least one laser component (4) with several laser-light-emitting emitters that are offset against one another in a first X axis direction, which are arranged with their active layer in a common X-Z plane that encloses the first X axis direction, the plate fan (8, 9) that forms the second deformation element lies with the planes of the surface faces (12') of its plates (12) parallel to the plane of the active layer.

17. Laser lens in accordance with claim 14 and 15, **characterised in that** in the case of at least two plate fans (8, 9) arranged behind one another in the beam path, the first plate fan (8) which follows the laser diode arrangement (2, 2a) in the beam path is arranged with the planes of the surface faces (12') of its plates (12) perpendicular to the plane of the active layer, and the second plate fan (9) which follows the laser diode arrangement (2, 2a) in the beam path is arranged with the planes of the surface faces (12') of its plates (12) parallel to the plane of the active layer.

18. Laser lens in accordance with one of the preceding claims, **characterised in that** provided on the optical arrangement formed by the deformation elements (8, 9), in the beam path, there is at least one further optical arrangement that shapes the beam, for example a focusing arrangement and/or collimator (17).

19. Laser lens in accordance with one of the preceding claims, **characterised in that** in the beam path, before the optical arrangement formed by the deformation elements (8, 9), there is a further optical arrangement that shapes the beam, for example at least one collimator (6) and/or a focusing arrangement (19).

20. Laser lens in accordance with one of the preceding claims, **characterised in that** where at least one laser diode arrangement (2, 2a) is used with laser components (4) arranged over one another in several planes in a Y axis direction perpendicular to the active layer, provided between the laser diode arrangement (2a) and the optical arrangement (7) formed by the deformation elements (8, 9), there is a focusing lens (19) which focuses the laser beam,
wherein for example there is provided a focusing lens (19) which focuses the laser beam in the area of the deformation elements (8, 9) or in the area of the optical arrangement (7) formed by these elements,
wherein for example a focusing lens (19) which has an astigmatism is provided, which focuses the laser beam into a first plane, for example in the X-Z plane defined by the first X axis and the Z beam axis, and on an area that follows on in the Z beam direction, in a second plane lying perpendicular to the first plane, for example in the Y-Z plane defined by the second Y axis and the Z beam axis, and/or
wherein for example [a] focusing lens is provided which focuses the laser beam in the first X-Z plane onto the entry surface of the first deformation element (8), and in the second Y-Z plane onto the entry surface of the second deformation element (9).

21. Laser lens in accordance with one of the preceding claims, **characterised in that** in the case of at least one of the deformation elements executed as a plate fan, in order to achieve the same running times or path lengths of the beams that are guided through the various plates, the plates (12) are adjusted or set relative to one another at least in the beam direction.

22. Diode laser with at least one laser diode arrangement (2, 2a) as a radiation source, which has at least one laser component (4) with several laser-light-emitting emitters which are offset against one another in a first X axis direction, which are arranged with their active layer in a common X-Z plane that encloses the first X axis direction, as well as with a laser lens with at least one optical arrangement (7), arranged in a common laser beam (5) of the emitters, for shaping the laser beam,
**characterised in that**
the laser lens of the diode laser is designed in accordance with one of the claims 1-21.

## Revendications

1. Optique à laser pour convertir au moins un faisceau laser, qui présente une section transversale en forme de ligne ou de bande s'étendant dans une première direction axiale X perpendiculaire à l'axe Z du faisceau, avec au moins deux éléments de conversion optiques (8, 9, 22) agencés l'un à la suite de l'autre dans la trajectoire du faisceau, dont au moins l'un est un élément traversé par le faisceau laser et qui forment un aménagement optique (7),
- dans laquelle il se fait une distribution en éventail du au moins un faisceau laser (5) en plusieurs faisceaux partiels parallèles, respectivement, dans un plan Y-Z perpendiculaire au premier axe X, les faisceaux partiels parallèles (5') étant décalés les uns des autres autant dans la première direction axiale X que dans une seconde direction axiale Y, qui est perpendiculaire à l'axe Z du faisceau et perpendiculaire au premier axe Y,
- dans laquelle il se fait ensuite un regroupement des faisceaux partiels distribués en éventail, et
- dans laquelle le second élément de conversion optique effectue un déplacement des faisceaux partiels (5') formés dans le premier élément de conversion optique, respectivement, dans un plan X-Z parallèle au premier axe X de sorte que, dans le faisceau laser sortant du second élément optique (9, 22), les faisceaux partiels parallèles (5 ) soient déplacés en superposition et soient décalés les uns des autres seulement ou sensiblement seulement encore dans le second axe Y,
**caractérisée en ce que** :
au moins un élément de conversion optique est un éventail à lames (8), qui est constitué de plusieurs lames (12) en matériau guidant la lumière, qui sont décalées dans la direction perpendiculaire à leurs faces et dans lesquels se fait un guidage du faisceau par réflexion totale, et dans laquelle :
- les lames (12) forment, respectivement, un premier chant de lame plan (13) et, en regard de celui-ci, un second chant de lame plan (14),
- le premier chant de lame (13) et le second chant de lame (14) de chaque lame sont parallèles l'un à l'autre,
- les chants de lames (13, 14) subissent une rotation mutuelle en éventail de sorte que le premier chant (13) de chaque lame (12) se situe dans un plan qui inclut un angle α avec le plan du premier chant (13) de chaque lame adjacente (12),
- les premiers chants de lames (13) dans leur ensemble et les seconds chants de lames (14) dans leur ensemble forment, respectivement, un premier côté (10) de l'éventail à lames et un second côté (11) de l'éventail à lames, respectivement, pour l'entrée ou la sortie du au moins un faisceau laser traversant l'éventail à lames,
- les plans (E) des chants de lames (13, 14) ainsi que l'axe d'éventail (A) sont perpendiculaires aux faces (12') des lames (12).

2. Optique à laser selon la revendication 1, **caractérisée en ce que** le premier élément de conversion optique effectue la distribution en éventail du au moins un faisceau laser (5) en plusieurs faisceaux partiels parallèles, respectivement, dans un plan Y-Z perpendiculaire au premier axe X.

3. Optique à laser selon la revendication 1 ou 2, **caractérisée en ce que** les lames (12) sont aménagées successivement en pile perpendiculairement à leurs faces.

4. Optique à laser selon l'une quelconque des revendications précédentes, **caractérisée en ce que** les plans (E) des premiers chants de lames (13) sont décalés les uns des autres par rotation autour d'au moins un axe d'éventail (A).

5. Optique à laser selon la revendication 4, **caractérisée en ce que** les plans des premiers champs de lames sont décalés les uns des autres par rotation autour d'un axe d'éventail commun (A).

6. Optique à laser selon la revendication 4, **caractérisé en ce que** les plans (E) des premiers chants de lames (13) sont décalés les uns des autres par déplacement ou rotation autour d'au moins deux axes d'éventail différents (A).

7. Optique à laser selon l'une quelconque des revendications précédentes, **caractérisée en ce que** le premier élément de conversion optique est un éventail à lames (8) qui est agencé de préférence avec les plans des faces (12') de ses lames (12) parallèles à un plan Y-Z défini par l'axe Z du faisceau et par le deuxième axe Y et se situe avec son axe d'éventail (A) parallèle au premier axe X.

8. Optique à laser selon l'une quelconque des revendications précédentes, **caractérisée en ce que** le second élément de conversion optique est un éventail à lames (9) qui est agencé de préférence avec les plans des faces (12') de ses lames (12) parallèles à un plan X-Z défini par l'axe Z du faisceau et par le premier axe X et se situe avec son axe d'éventail (A) parallèle au second axe Y.

9. Optique à laser selon la revendication 7 ou 8, **caractérisée en ce que** les deux éventails à lames (8, 9) formant le premier et le second élément de conversion optique sont agencés décalés l'un de l'autre par rotation d'un angle de 90° autour de l'axe Z du faisceau de sorte que l'éventail à lames (8) formant le premier élément de conversion optique se situe avec les plans des faces (12') de ses lames perpendiculaires aux plans des faces des lames du second éventail à lames (9) et **en ce que** les deux éventails à lames (8, 9) sont de préférence tournés l'un vers l'autre avec leur second côté d'éventail à lames (11).

10. Optique à laser selon l'une quelconque des revendications précédentes, **caractérisée en ce que** le guidage du faisceau se fait par réflexion totale dans les lames (12) de l'éventail à lames (8, 9), de préférence dans les lames (12) de l'éventail à lames (8) formant le premier élément de conversion.

11. Optique à laser selon l'une quelconque des revendications précédentes, **caractérisée en ce que** le au moins un axe d'éventail (A) est en contact avec le premier chant (13) d'au moins une lame (12) ou se trouve dans le plan de ce chant de lame.

12. Optique à laser selon l'une quelconque des revendications précédentes, **caractérisée en ce que**, dans l'éventail (8, 9), les plans (E) du premier chant de lame incluent respectivement le même angle mutuellement.

13. Optique à laser selon l'une quelconque des revendications précédentes, **caractérisée en ce que**, dans l'éventail à lames (8, 9), en partant d'une lame
(12) située à l'extérieur, les premiers chants (13) des lames adjacentes ou leurs projections sur un plan parallèle aux faces (12') sont décalés les uns des autres respectivement dans le même sens.

14. Optique à laser selon l'une quelconque des revendications précédentes, **caractérisée en ce que**, pour obtenir une réflexion totale dans chaque lame (12), il est prévu sur les faces de cette lame, à proximité de chaque face, un milieu qui présente un indice de réfraction plus petit en comparaison de celui du matériau des lames,
dans laquelle il est prévu, par exemple entre deux lames adjacentes (12), une colle ou un ciment ayant un indice de réfraction optique plus petit en comparaison de celui du matériau des lames, et/ou
dans laquelle il est prévu, par exemple entre deux lames adjacentes, un intervalle d'air, et/ou
dans laquelle, par exemple, les lames (12) sont métallisées sur leurs faces (12').

15. Optique à laser selon l'une quelconque des revendications précédentes, **caractérisée en ce que**, lorsqu'on utilise au moins un aménagement de diodes laser (2, 2a) comme source de rayonnement, qui présente au moins un composant laser (4) avec plusieurs émetteurs irradiant de la lumière laser et décalés les uns des autres dans une première direction axiale X, qui sont agencés avec leur couche active dans un plan X-Z commun comprenant la première direction axiale X, l'éventail à lames (8, 9) formant le premier élément de conversion se trouve avec les plans des faces (12') de ses lames (12) perpendiculaires au plan de la couche active.

16. Optique à laser selon l'une quelconque des revendications précédentes, **caractérisée en ce que**, lorsqu'on utilise au moins un aménagement de diodes laser (2, 2a) comme source de rayonnement, qui présente au moins un composant laser (4) avec plusieurs émetteurs irradiant de la lumière laser et décalés les uns des autres dans une première direction axiale X, qui sont agencés avec leur couche active dans un plan X-Z commun comprenant la première direction axiale X, l'éventail à lames (8, 9) formant le second élément de conversion se trouve avec les plans des faces (12') de ses lames (12) parallèles au plan de la couche active.

17. Optique à laser selon les revendications 14 et 15, **caractérisée en ce que**, dans au moins deux éventails à lames (8, 9) agencés l'un derrière l'autre dans la trajectoire du faisceau, le premier éventail à lames (8, 9) suivant dans la trajectoire du faisceau l'aménagement de diodes laser (2, 2a) est agencé avec les plans des faces (12') de ses lames (12) perpendiculaires au plan de la couche active et le second éventail à lames (9) suivant dans la trajectoire du faisceau l'aménagement de diodes laser (2, 2a) est agencé avec les plans des faces (12') de ses lames (12) parallèles au plan de la couche active.

18. Optique à laser selon l'une quelconque des revendications précédentes, **caractérisée en ce qu'**il est prévu, sur l'aménagement optique formé par les éléments de conversion (8, 9) dans la trajectoire du faisceau, au moins un autre aménagement optique formant le faisceau, par exemple un aménagement de focalisation et/ou un collimateur (17).

19. Optique à laser selon l'une quelconque des revendications précédentes, **caractérisée en ce que**, dans la trajectoire du faisceau devant l'aménagement optique (7) formé par les éléments de conversion (8, 9), il est prévu un autre aménagement formant le faisceau, par exemple au moins un collimateur (6) et/ou un dispositif de focalisation (19).

20. Optique à laser selon l'une quelconque des revendications précédentes, **caractérisée en ce que**, lors de l'utilisation d'un aménagement de diodes laser (2a) avec des composants laser agencés en superposition dans plusieurs plans dans une direction axiale Y perpendiculaire à la couche active, il est prévu entre l'aménagement de diodes laser (2a) et l'aménagement optique (7) formé par les éléments de conversion (8, 9) une optique de focalisation (19) focalisant le faisceau laser,
dans laquelle il est prévu, par exemple, une optique de focalisation (19) focalisant le faisceau laser dans la zone des éléments de conversion (8, 9) ou dans la zone de l'aménagement optique (7) formé par ces éléments, et/ou
dans laquelle il est prévu une optique de focalisation (19) présentant un astigmatisme, qui focalise le faisceau laser dans un premier plan, par exemple dans le plan X-Z défini par le premier axe X et l'axe Z du faisceau et dans une zone suivant dans la direction Z du faisceau dans un second plan perpendiculaire au premier plan, par exemple dans le plan Y-Z défini par le second axe Y et l'axe Z du faisceau, et/ou
dans lequel il est prévu, par exemple, une optique de focalisation qui focalise le faisceau laser dans le premier plan X-Z sur la face d'entrée du premier élément de conversion (8) et dans le second plan Y-Z sur la face d'entrée du second élément de conversion (9).

21. Optique à laser selon l'une quelconque des revendications précédentes, **caractérisée en ce qu'**au moins dans l'un des éléments de conversion se présentant sous la forme d'éventails à lames, les lames sont ajustées ou réglées l'une par rapport à l'autre pour obtenir des temps de parcours égaux ou des longueurs de déplacement égales des faisceaux guidés par les diverses lames au moins dans la direction des faisceaux.

22. Laser à diodes ayant au moins un aménagement de diodes laser (2, 2a) comme source de rayonnement, qui présente au moins un composant laser (4) avec plusieurs émetteurs irradiant de la lumière laser décalés les uns des autres dans une première direction axiale X, qui sont agencés avec leur couche active dans un plan X-Z commun comprenant la première direction axiale X, ainsi qu'une optique à laser avec au moins un aménagement optique (7) agencé dans le faisceau laser commun (5) des émetteurs pour former le faisceau laser, **caractérisé en ce que** l'optique à laser du laser à diodes est conformée selon l'une quelconque des revendications 1 à 21.
